# EUROPEAN PATENT SPECIFICATION

(11) **EP 2 159 833 B1**
(45) Date of publication and mention of the grant of the patent: **29.04.2015**
(21) Application number: 09169108.9
(22) Date of filing: 01.09.2009
(51) Int. Cl.: H01L 21/336, H01L 29/78, H01L 21/66, H01L 21/8238

(54) **Method of producing a semiconductor device**
Verfahren zur Herstellung einer Halbleitervorrichtung
Procédé de fabrication d'un dispositif semi-conducteur

(30) Priority: 02.09.2008 WO PCT/JP2008/065718
(43) Date of publication of application: 03.03.2010
(73) Proprietor: Unisantis Electronics Singapore Pte. Ltd., Singapore 179098 (SG)
(72) Inventor: Masuoka, Fujio, Tokyo 102-0073 (JP); Arai, Shintaro, Tokyo 102-0073 (JP)
(74) Representative: Kindermann, Peter

(56) References cited:
- US-B1- 6 281 068
- US-B1- 7 115 476

## Description

### TECHNICAL FIELD

The present invention relates to a method of producing a semiconductor device, and more particularly to a structure and a production method for an SGT (Surrounding Gate Transistor) which is a vertical MOS transistor comprising a pillar-shaped semiconductor layer having a sidewall serving as a channel region, and a gate electrode formed to surround the channel region. In particular the present invention relates to a method of producing a semiconductor device in which a source diffusion layer, a drain diffusion layer and a pillar-shaped semiconductor layer are vertically arranged on an upper side of a substrate in a layered manner, and a gate is arranged around a sidewall of the pillar-shaped semiconductor layer. Further, the present invention relates to a method of producing a semiconductor device in which a source diffusion layer, a drain diffusion layer and a pillar-shaped semiconductor layer are vertically arranged on an upper side of a substrate in a layered manner, and a gate is arranged around a sidewall of the pillar-shaped semiconductor layer.

### BACKGROUND ART

With a view to achieving higher integration and higher performance of a semiconductor device, an SGT (Surrounding Gate Transistor) has been proposed which is a vertical transistor comprising a pillar-shaped semiconductor layer formed on a surface of a semiconductor substrate, and a gate formed to surround a sidewall of the pillar-shaped semiconductor layer (see Patent Document 1: JP 2-188966A). In the SGT, a source, a gate and a drain are arranged in a vertical direction, so that an occupancy area can be significantly reduced as compared with a conventional planar transistor.

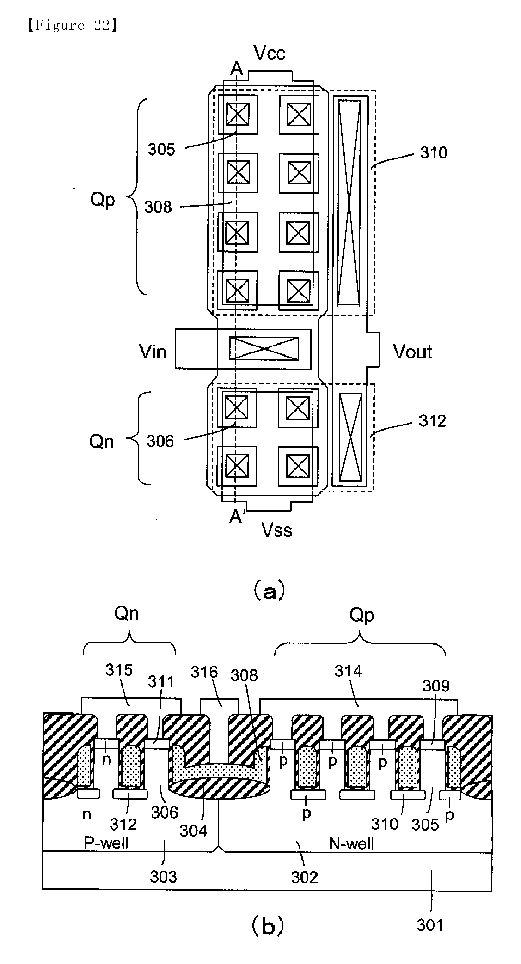

FIG. 22(a) shows a top plan view of a prior art CMOS inverter configured using the SGT disclosed in the Patent Document 1, and FIG. 22(b) is a sectional view taken along the cutting-plane line A-A' in the top plan view of FIG. 22(a).

Referring to FIGS. 22(a) and 22(b), an N-well 302 and a P-well 303 are formed in an upper region of a Si substrate 301. A pillar-shaped silicon layer 305 forming a PMOS (PMOS-forming pillar-shaped silicon layer 305) and a pillar-shaped silicon layer 306 forming an NMOS (NMOS-forming pillar-shaped silicon layer 306) are formed on a surface of the Si substrate, specifically on respective ones of the N-well region and the P-well region, and a gate 308 is formed to surround the pillar-shaped silicon layers. Then, each of a P⁺ drain diffusion layer 310 formed beneath the PMOS-forming pillar-shaped silicon layer, and a N⁺ drain diffusion layer 312 formed beneath the NMOS-forming pillar-shaped silicon layer, is connected to an output terminal Vout. A source diffusion layer 309 formed on a top of the PMOS-forming pillar-shaped silicon layer is connected to a power supply potential Vcc, and a source diffusion layer 311 formed on a top of the NMOS-forming pillar-shaped silicon layer is connected to a ground potential Vss. Further, the gate 308 common to the PMOS and the NMOS is connected to an input terminal Vin. In this manner, the CMOS inverter is formed.

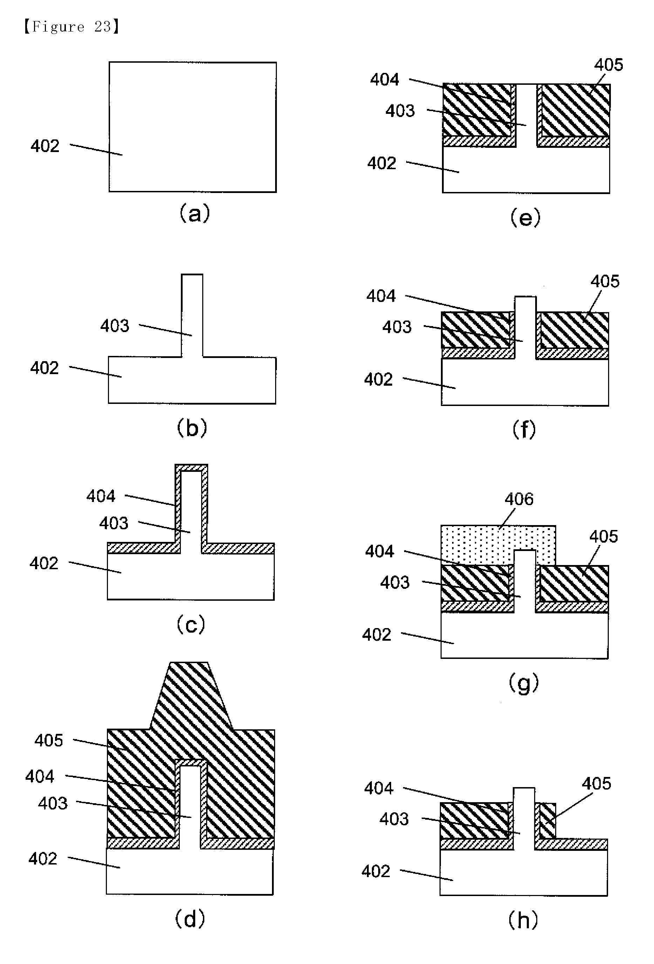

As one example of a prior art SGT production method, a process flow is disclosed in the following Non-Patent Document 1. FIG. 23 shows a prior art schematic process flow for forming a pillar-shaped silicon layer and a gate electrode in an SGT disclosed in the Non-Patent Document 1. The following description will be made about this process flow. As shown in FIG. 23(b), a silicon substrate 402 illustrated in FIG. 23 (a) is etched to form a pillar-shaped silicon layer 403. Then, as shown in FIG. 23(c), a gate dielectric film 404 is formed. Then, as shown in FIG. 23(d), a gate conductive film 405 is formed. Then, as shown in FIG. 23(e), the gate conductive film 405, and a portion of the gate dielectric film 404 on a top of the pillar-shaped silicon layer, are polished by chemical mechanical polishing (CMP). Then, as shown in FIG. 23(f), the gate conductive film 405 is etched back in such a manner that the gate conductive film 405 surrounding the pillar-shaped silicon layer is fabricated to have a desired gate length. Then, as shown in FIG. 23(g), a resist 406 for a gate line pattern is formed by lithography. Then, as shown in FIG. 23(h), the gate conductive film 405 is etched to form a gate electrode and a gate line.

Patent Document 1: JP 2-188966A
Non-Patent Document 1: Ruigang Li, et al., "50 nm Vertical Surround Gate MOSFET with S-Factor of 75 mV/dec", Device Research Conference, 2001, p. 63

US 7,115,476 concerns a method of manufacturing a semiconductor device includes forming a mask layer on a semiconductor substrate, etching the semiconductor substrate using the mask layer as a mask, thereby forming a semiconductor pillar, doping an impurity into the semiconductor substrate, thereby forming a first source/drain region in part of the semiconductor substrate, which is located under the semiconductor pillar, forming a gate insulating film on the semiconductor substrate, which contacts a side surface of the semiconductor pillar, forming a gate electrode on a side surface of the gate insulating film, forming a first insulating layer on the gate electrode, which contacts a side surface of the semiconductor pillar, and doping the impurity into the first insulating layer, thereby forming a second source/drain region in part of the semiconductor pillar, which is located on a side surface of the first insulating layer.

US 6,281,068 concerns a method of forming the buried plate regions in deep trench capacitors used in DRAM memory semiconductor circuits in which the polymer used in the deep trench is etched down to the desired depth in a reactive ion etch tool using an O2/CF4 chemistry.

### DISCLOSURE OF THE INVENTION

### [PROBLEM TO BE SOLVED BY THE INVENTION]

However, the SGT production method illustrated in FIG. 23 has the following problem. During dry etching for forming a gate electrode in the above process flow, an etching end-point has to be based on a designated etching time, because it is unable to employ an end-point detection process based on monitoring a change in plasma emission intensity. In this case, during the dry etching, a variation in etching rate of an etching apparatus in each lot or in each wafer has a direct impact on gate length to cause a significantly large variation in gate length. The larger variation in gate length undesirably leads to a larger variation in transistor characteristics.

Thus, in order to reduce a variation in SGT characteristics, it has advantages to employ an end-point detection process capable of absorbing the variation in etching rate in each lot or in each wafer.

In view of the above circumstances, it is an object of embodiments of the present invention to produce an SGT in which the stability of the gate length is improved. In particular, the stable gate length may be produced using an end-point detection process based on monitoring a plasma emission intensity during dry etching for setting a gate length.

### [MEANS FOR SOLVING THE PROBLEM]

In light of the above, the method according to independent claim 1 is provided. Further advantages, features, aspects and details are evident from the dependent claims, the description and the drawings.

According to the present invention there is provided a method of producing a semiconductor device in which a source diffusion layer, a drain diffusion layer and a pillar-shaped semiconductor layer are vertically arranged on an upper side of a semiconductor substrate in a layered manner, and a gate is arranged around a sidewall of the pillar-shaped semiconductor layer, the method comprising the steps of: forming a first film to cover respective surfaces of the pillar-shaped semiconductor layer and a hard mask formed on top of the pillar-shaped semiconductor layer; flattening an upper portion of the first film using the hard mask as a stopper; comprising the steps: forming a second film on a surface of the flattened first film, wherein the first and second films are made of the same material; anisotropically etching the second film; monitoring an intensity of plasma emission from the second film during the etching, to detect an end-point of the etching of the second film, based on a change in the plasma emission intensity; and anisotropically etching the flattened first film, wherein the etching rate of the first and second films is calculated from a film thickness of the second film and a time taken from initiation to completion of the etching of the second film to detect an end-point of the etching of the flattened first film.

### BRIEF DESCRIPTION OF THE DRAWINGS

So that the manner in which the above recited features of the present invention can be understood in detail, a more particular description of the invention, briefly summarized above, may be made by reference to embodiments. The accompanying drawings relate to embodiments of the invention and are described in the following:
FIGS. 1 (a) and 1(b) are, respectively, a top plan view and a sectional view of an SGT produced by a method according to a first embodiment of the present invention.
FIGS. 2(a) and 2(b) are process flow diagrams showing the production method according to the first embodiment, in order of process sequence.
FIGS. 3 (a) and 3(b) are process flow diagrams showing the production method according to the first embodiment, in order of process sequence.
FIGS. 4(a) and 4(b) are process flow diagrams showing the production method according to the first embodiment, in order of process sequence.
FIGS. 5(a) and 5(b) are process flow diagrams showing the production method according to the first embodiment, in order of process sequence.
FIGS. 6(a) and 6(b) are process flow diagrams showing the production method according to the first embodiment, in order of process sequence.
FIGS. 7(a) and 7(b) are process flow diagrams showing the production method according to the first embodiment, in order of process sequence.
FIGS. 8(a) and 8(b) are process flow diagrams showing the production method according to the first embodiment, in order of process sequence.
FIGS. 9(a) and 9(b) are process flow diagrams showing the production method according to the first embodiment, in order of process sequence.
FIGS. 10(a) and 10(b) are graphs each showing a characteristic curve of plasma emission intensity in the production method according to the first embodiment.
FIGS. 11(a) and 11(b) are process flow diagrams showing the production method according to the first embodiment, in order of process sequence.
FIGS. 12(a) and 12(b) are process flow diagrams showing the production method according to the first embodiment, in order of process sequence.
FIGS. 13(a) and 13(b) are process flow diagrams showing the production method according to the first embodiment, in order of process sequence.
FIGS. 14(a) and 14(b) are process flow diagrams showing the production method according to the first embodiment, in order of process sequence.
FIGS. 15(a) and 15(b) are, respectively, a top plan view and a sectional view of an SGT produced by a method according to a second embodiment of the present invention.
FIGS. 16(a) and 16(b) are process flow diagrams showing the production method according to the second embodiment, in order of process sequence.
FIGS. 17(a) and 17(b) are process flow diagrams showing the production method according to the second embodiment, in order of process sequence.
FIGS. 18(a) and 18(b) are process flow diagrams showing the production method according to the second embodiment, in order of process sequence.
FIGS. 19(a) and 19(b) are process flow diagrams showing the production method according to the second embodiment, in order of process sequence.
FIGS. 20(a) and 20(b) are process flow diagrams showing the production method according to the second embodiment, in order of process sequence.
FIGS. 21 (a) and 21(b) are process flow diagrams showing the production method according to the second embodiment, in order of process sequence.
FIGS. 22(a) and 22(b) are, respectively, a top plan view and a sectional view of a conventional SGT.
FIGS. 23(a) to 23(h) are process flow diagrams showing a conventional SGT production method.

### BEST MODE FOR CARRYING OUT THE INVENTION

The present invention will now be described based on an SGT production method according to an embodiment thereof, which is capable of detecting an etching end-point by monitoring a plasma emission intensity, during dry etching for forming a gate electrode.

### FIRST EMBODIMENT

An SGT production method according to a first embodiment of the present invention provides a technique of, during dry etching for forming a gate conductive film to have a desired gate length, accurately controlling an etching amount of the gate conductive film, using an end-point detection process based on monitoring a plasma emission intensity.

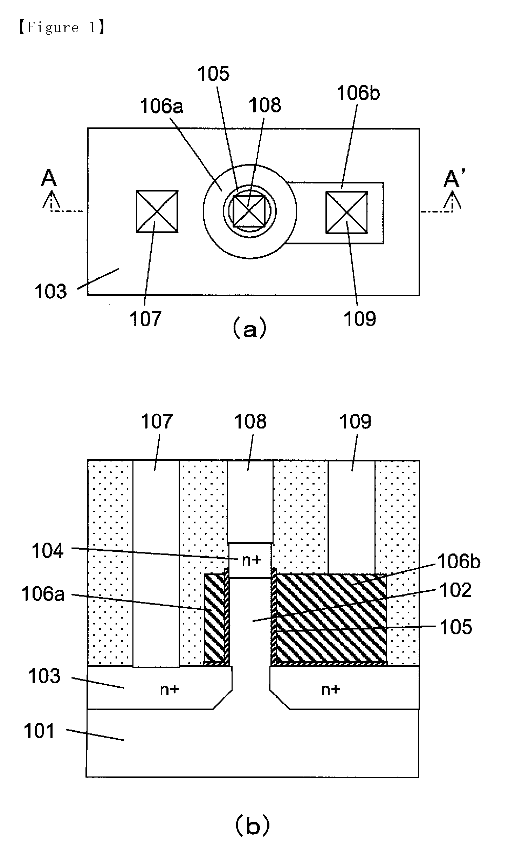

FIG. 1(a) is a top plan view showing an NMOS SGT produced by the method according to the first embodiment, and FIG. 1(b) is a sectional view taken along the line A-A' in FIG. 1(a). With reference to FIGS. 1(a) and 1(b), the SGT produced by the method according to the first embodiment will be described below.

A pillar-shaped silicon layer 102 is formed on a silicon substrate 101, and a gate dielectric film 105 and a gate electrode 106a are formed around the pillar-shaped silicon layer 102. An N⁺ drain diffusion layer 103 is formed beneath the pillar-shaped silicon layer 102, and an N⁺ source diffusion layer 104 is formed on a top of the pillar-shaped silicon layer 102. A contact 107, a contact 108, and a contact 109, are formed on the N⁺ drain diffusion layer 103, the N⁺ source diffusion layer 104, and a gate line 106b extending from the gate electrode 106a, respectively.

Under conditions that the N⁺ source diffusion layer 104 is connected to a GND potential, and the N⁺ drain diffusion layer 103 is connected to a power supply voltage Vcc, a potential ranging from zero to Vcc is applied to the gate electrode 106a to allow the SGT to operate as a transistor. Practically, there is another type of SGT adapted to operate under a condition that the source diffusion layer and the drain diffusion layer are interchanged.

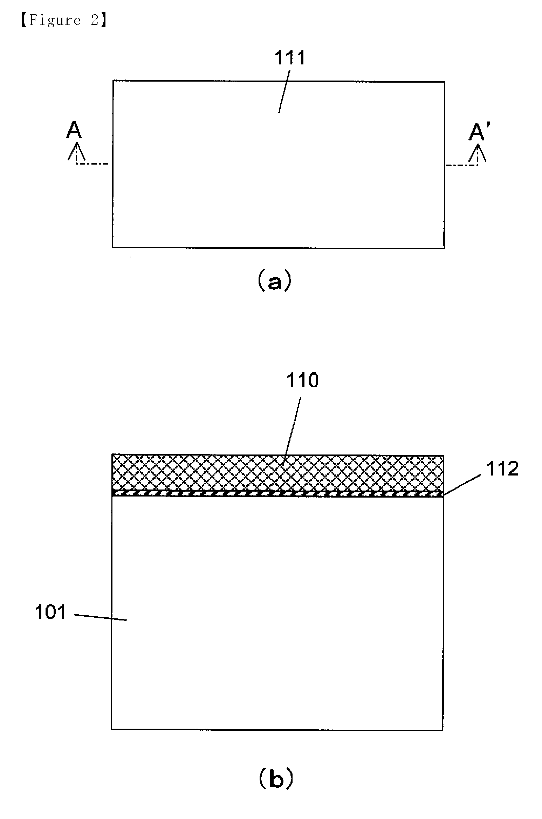

FIGS. 2(a) to 14(b) show one example of the SGT production method which allows for the etching for accurately forming a pillar-shaped silicon layer. In FIGS. 2(a) to 14(b), the figure suffixed by (a) is a top plan view, and the figure suffixed by (b) is a sectional view taken along the line A-A'.

As shown in FIGS. 2(a) and 2(b), a pad oxide film 112 is formed on a silicon substrate 101 to serve as a pad for reducing a stress between the silicon substrate and an after-mentioned hard mask. Subsequently, a silicon nitride film 110 is formed on the pad oxide film 112 to serve as a hard mask.

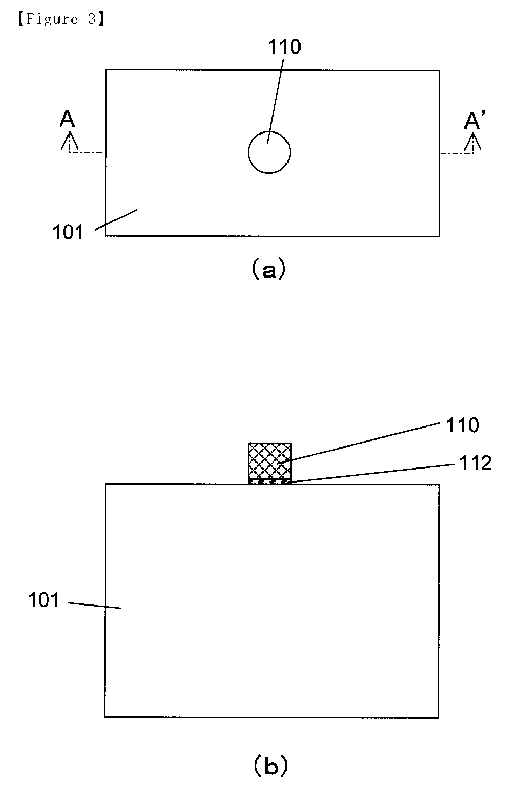

As shown in FIGS. 3(a) and 3(b), a resist is patterned by lithography using a mask for a pillar-shaped silicon layer, and the pad oxide film 112 and the hard mask 110 are patterned by dry etching.

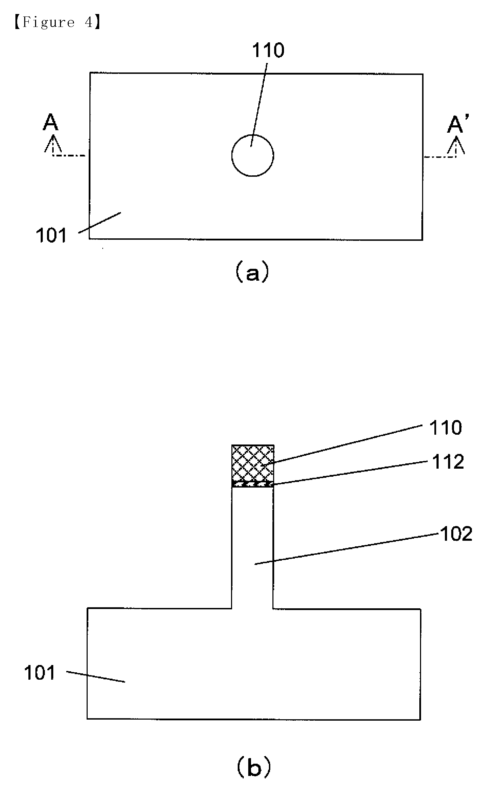

As shown in FIGS. 4(a) and 4(b), the silicon substrate 101 is etched using the hard mask 110 to form a pillar-shaped silicon layer 102.

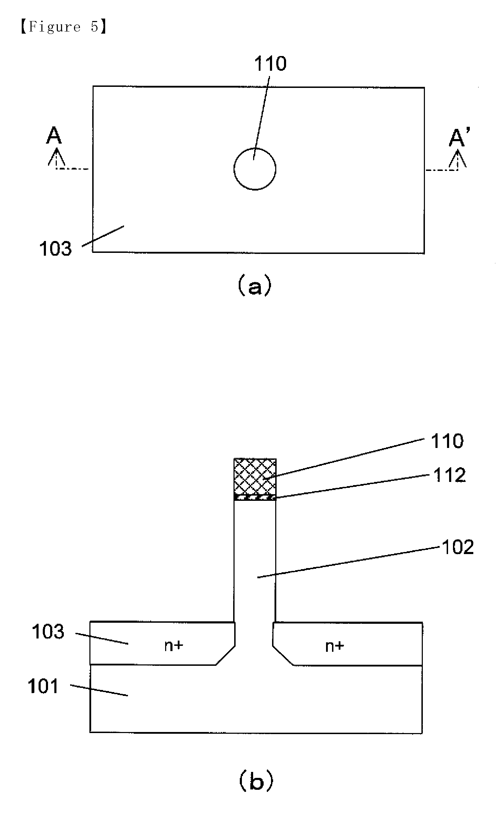

As shown in FIGS. 5(a) and 5(b), an N+ diffusion layer 103 is formed in a diffusion region beneath the pillar-shaped silicon layer 102, by means of ion implantation or the like.

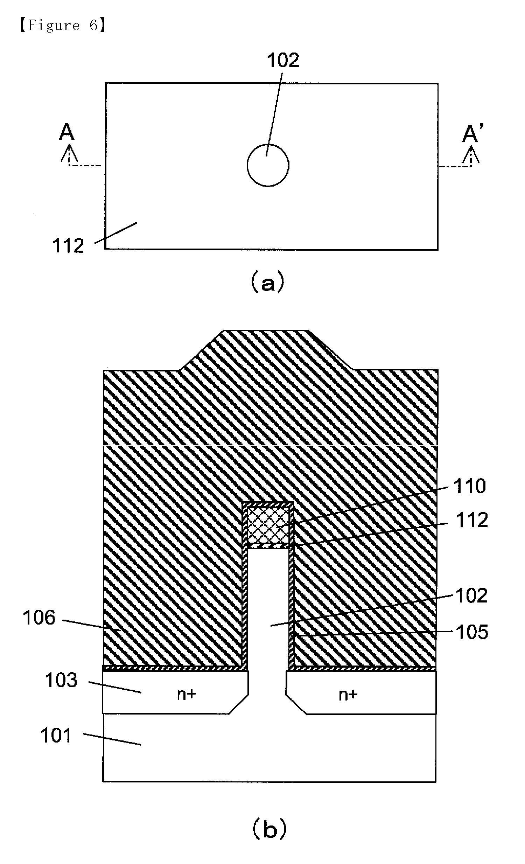

As shown in FIGS. 6(a) and 6(b), a gate dielectric film 105 is formed. Subsequently, a first gate conductive film 106 made of polysilicon is formed to allow the pillar-shaped silicon layer 102 to be buried therein.

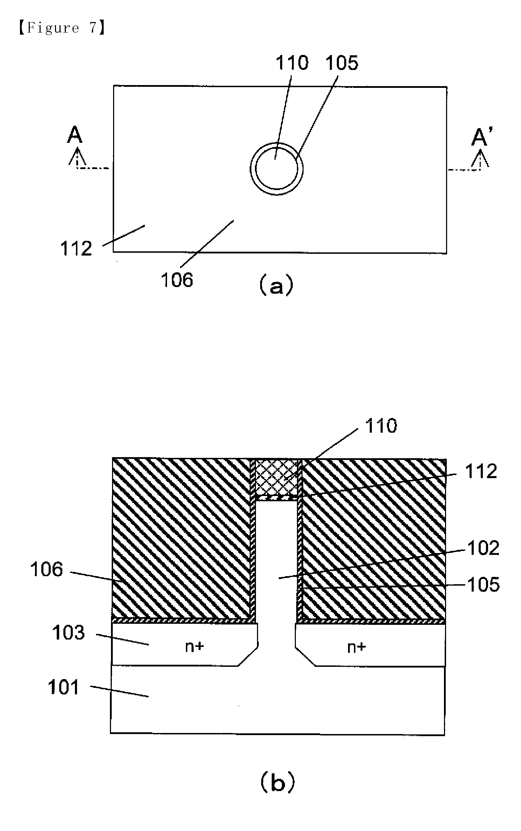

As shown in FIGS. 7(a) and 7(b), respective portions of the first gate conductive film 106 and the gate dielectric film 105 above the pillar-shaped silicon layer 102 are polished by chemical mechanical polishing (CMP), to flatten a top surface of the first gate conductive film 106. The flattening of a top of the gate conductive film 106 by CMP facilitates control of a gate length, as described later. During the CMP, the hard mask 110 on top of the pillar-shaped silicon layer is used as a CMP stopper. A silicon nitride film may be used as the hard mask, as in the first embodiment. In this case, a selectivity ratio between the hard mask and the gate conductive film can be set to a large value to control a CMP amount with high repeatability.

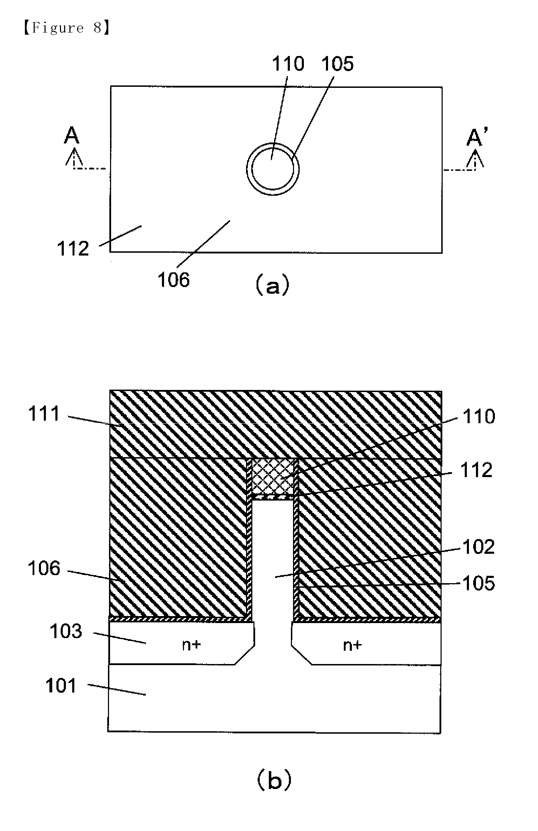

As shown in FIGS. 8(a) and 8(b), a second gate conductive film 111 made of polysilicon is formed.

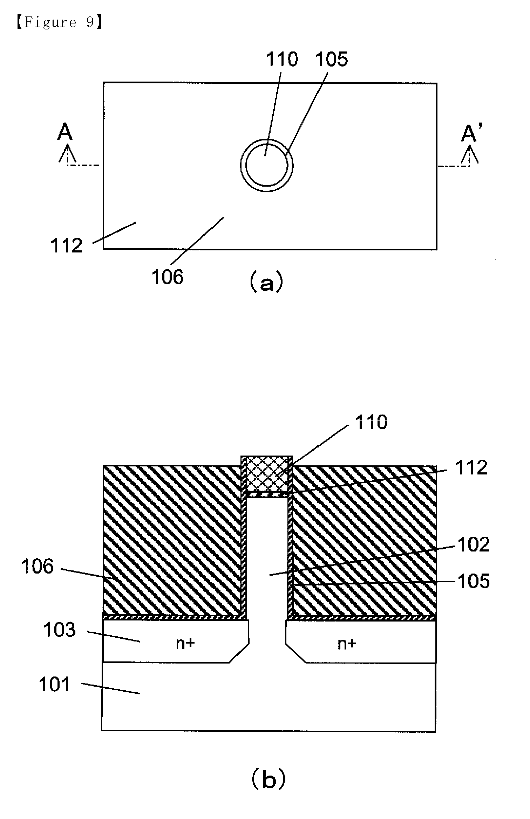

As shown in FIGS. 9(a) and 9(b), the second gate conductive film 111 is etched back. FIG. 9(b) shows a structure at a timing when an etching end-point is detected after the hard mask is exposed.

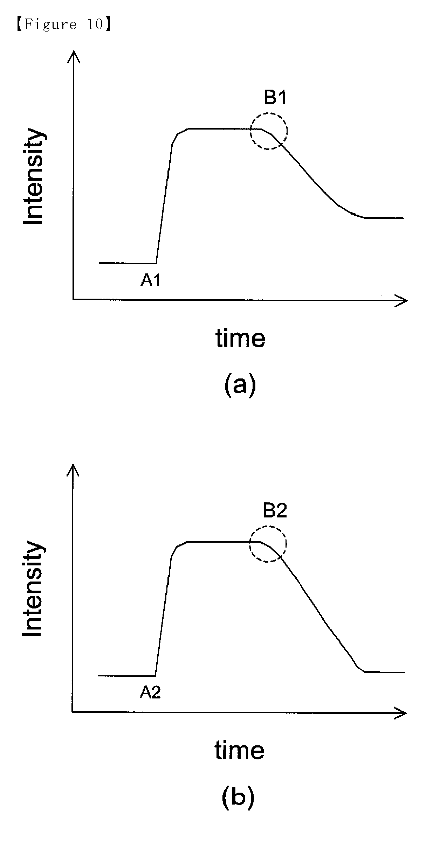

As shown in a characteristic curve of plasma emission intensity during the etching-back in FIG. 10(a), the plasma emission intensity sharply increases just after initiation of the etching (point A1). Then, when the hard mask starts being exposed, an amount of polysilicon to be etched decreases. Thus, the plasma emission intensity starts decreasing (point B1). An etching end-point can be detected by monitoring the above decrease in the plasma emission intensity. A film thickness of the second gate conductive film to be etched before the exposure of the hard mask depends on an amount of the second gate conductive film to be formed. Thus, an etching rate of the second gate conductive film 111 can be calculated based on the film thickness of the second gate conductive and a time taken from initiation to completion of the etching. In this regard, the top of the first conductive film 106 flattened by polishing in advance as described above makes it possible to accurately determine an etched amount and an etching time of the second gate conductive film so as to accurately calculate an etching rate of the second gate conductive film. This etching rate can be used to calculate an overetching amount for a desired film thickness in consideration of an etching rate during etching of the first gate conductive film, so that a gate length can be set in a stable manner. Specifically, an etching rate for actually etching the first gate conductive film can be calculated, based on an etching rate of the second gate conductive film calculated during actual etching of the second gate conductive film, and a relative ratio between respective etching rates of the first and second gate conductive films. Then, an etching time required for allowing the first gate conductive film to have a desired film thickness can be accurately obtained based on the above etching rate of the first gate conductive film.

The hard mask 110 on top of the pillar-shaped silicon layer also has a function of protecting the pillar-shaped silicon layer from being etched during the above etching.

In the first embodiment, each of the first gate conductive film and the second gate conductive film is made of polysilicon. Alternatively, the first gate conductive film and the second gate conductive film may be made of the same metal material.

In an example not covered by the present invention where the first gate conductive film and the second gate conductive film are made of different metal materials, an intensity of plasma emission from the second gate conductive film has a characteristic curve as shown in FIG. 10(b). Specifically, the plasma emission intensity sharply increases just after initiation of the etching (point A2). Then, when the hard mask is exposed, the second gate conductive film is fully etched away. Thus, the plasma emission intensity starts decreasing (point B2). An etching end-point can be detected by monitoring the above decrease in the plasma emission intensity.

According to the present invention, where the first gate conductive film and the second gate conductive film are made of the same material, an etching amount of the first gate conductive film can be controlled in the same manner, as long as a relative ratio between respective etching rates of the first and second gate conductive films can be found out.

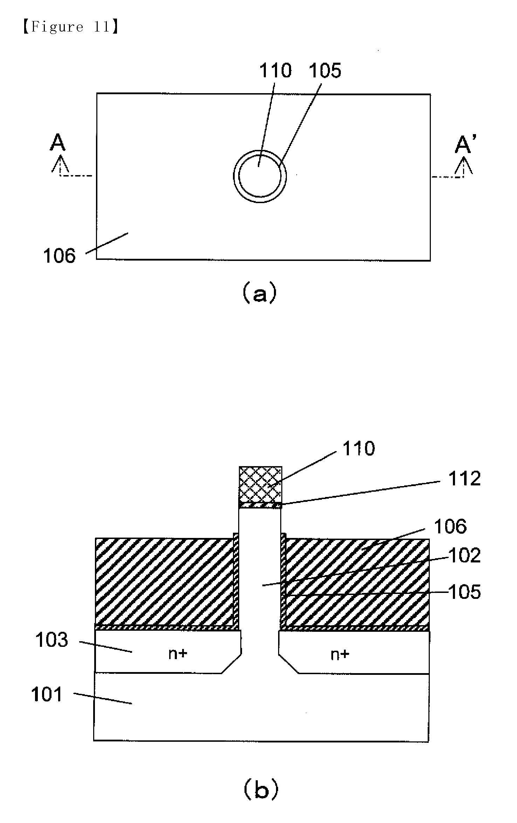

As described above, an etching time of the first gate conductive film is determined based on an accurate etching rate of the first gate conductive film. Thus, after completion of dry etching, the gate conductive film is formed to have a desired gate length for a gate electrode, as shown in FIGS. 11 (a) and 11(b).

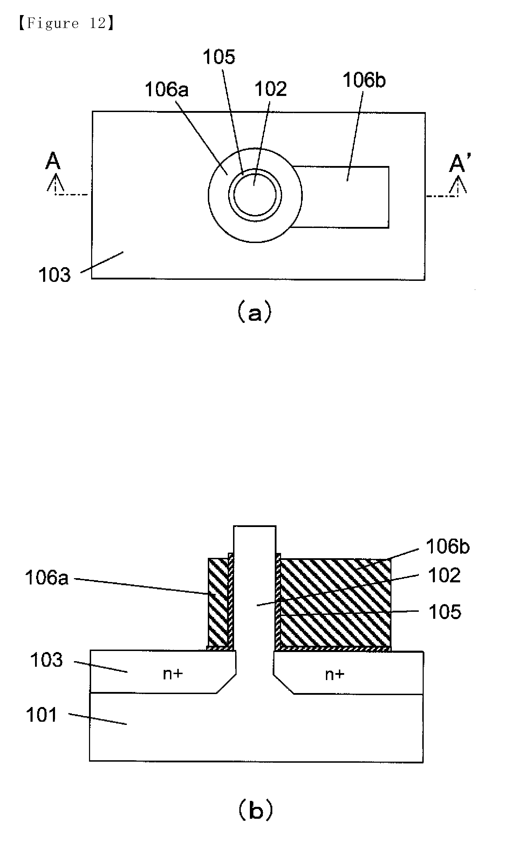

As shown in FIGS. 12(a) and 12(b), the pad oxide film 112 and the hard mask 110 is removed by dry etching or wet etching. Subsequently, the gate conductive film is patterned to form a gate electrode 106a surrounding the pillar-shaped silicon layer, and a gate line 106b on which a contact is to be formed.

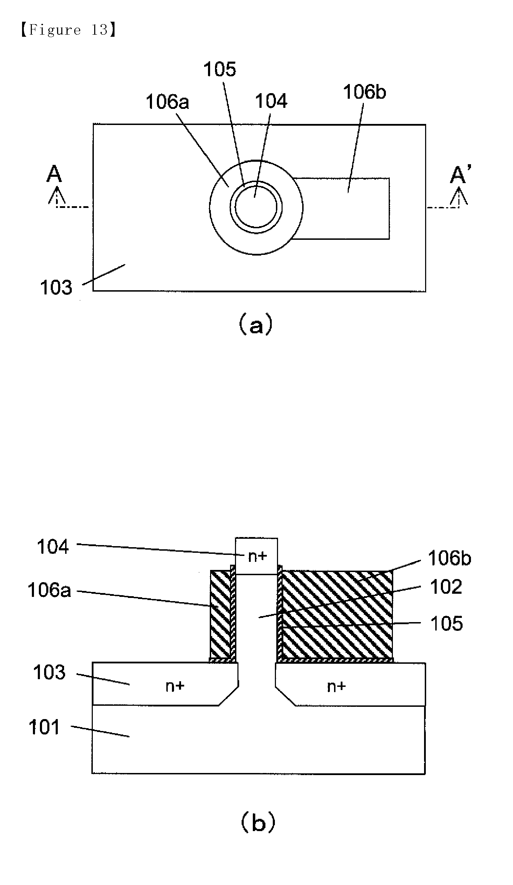

As shown in FIGS. 13(a) and 13(b), an N+ source diffusion layer 104 is formed in an upper portion of the pillar-shaped silicon layer, by means of ion implantation or the like.

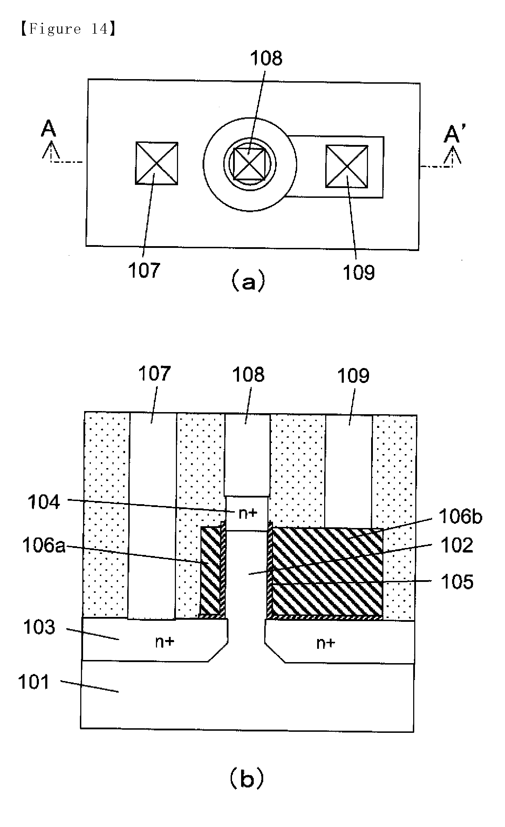

As shown in FIGS. 14(a) and 14(b), an interlayer film is formed, and a contact (107, 108, 109) is formed. In the above manner, an SGT is formed.

### SECOND EMBODIMENT

An SGT production method according to a second embodiment of the present invention provides a technique of, during dry etching for forming a silicon oxide film to have a desired thickness for reducing a gate capacitance in such a manner as to be interposed between a gate electrode and a portion of a substrate beneath a pillar-shaped silicon layer, accurately controlling an etching amount of the silicon oxide film, using an end-point detection process based on monitoring a plasma emission intensity.

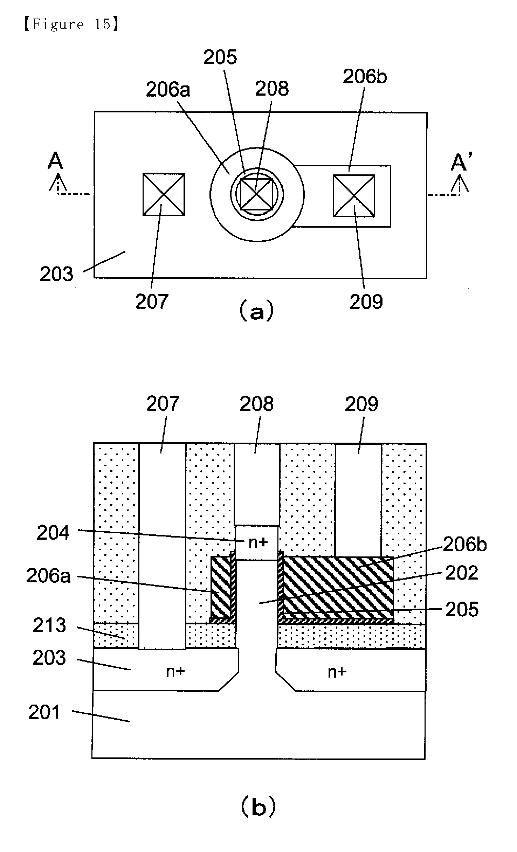

FIG. 15(a) is a top plan view showing an NMOS SGT produced by the method according to the second embodiment, and FIG. 15(b) is a sectional view taken along the line A-A' in FIG. 15(a). With reference to FIGS. 15(a) and 15(b), the SGT produced by the method according to the second embodiment will be described below.

A pillar-shaped silicon layer 202 is formed on a silicon substrate 201, and a gate dielectric film 205 and a gate electrode 206a are formed around the pillar-shaped silicon layer 202. An N⁺ drain diffusion layer 203 is formed beneath the pillar-shaped silicon layer 202, and an N⁺ source diffusion layer 204 is formed on a top of the pillar-shaped silicon layer 202. A silicon oxide film 213 is formed between the N⁺ drain diffusion layer 203 and the gate electrode 206a to reduce a gate capacitance. A contact 207, a contact 208, and a contact 209, are formed on the N⁺ drain diffusion layer 203, the N⁺ source diffusion layer 204, and a gate line 206b extending from the gate electrode 206a, respectively. The silicon oxide film 213 has a small film thickness of several tens of nm. Thus, it is necessary to accurately control the film thickness.

Under conditions that the N⁺ source diffusion layer 204 is connected to a GND voltage, and the N⁺ drain diffusion layer 203 is connected to a power supply potential Vcc, a voltage ranging from zero to Vcc is applied to the gate electrode 206a to allow the SGT to operate as a transistor. Practically, there is another type of SGT adapted to operate under a condition that the source diffusion layer and the drain diffusion layer are interchanged.

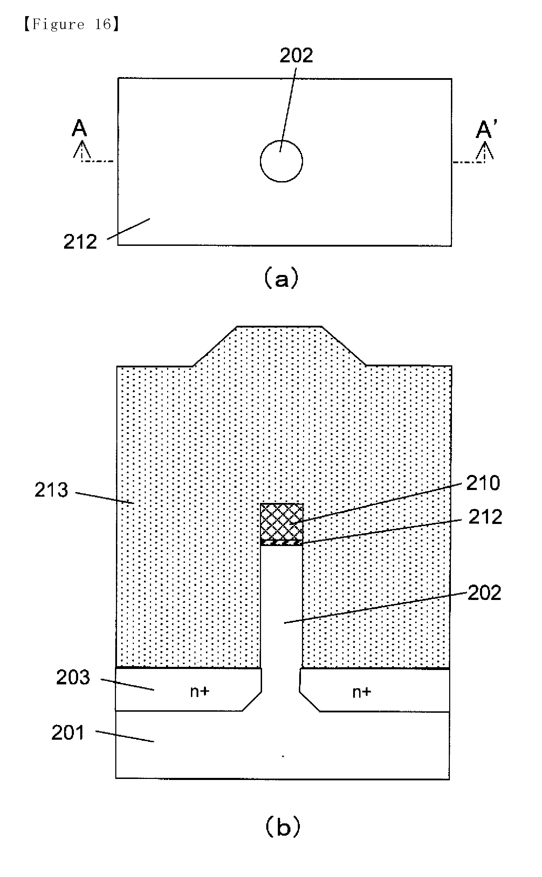

FIGS. 16(a) to 21(b) show one example of the SGT production method. In FIGS. 16(a) to 21(b), the figure suffixed by (a) is a top plan view, and the figure suffixed by (b) is a sectional view taken along the line A-A'. In the second embodiment, the step of forming an N⁺ drain diffusion layer (see FIGS. 5(a) and 5(b)) and any step therebefore are the same as those in the first embodiment. Thus, the following description will be made about steps subsequent to the N⁺ drain diffusion layer forming step.

As shown in FIGS. 16(a) and 16(b), a silicon oxide film 213 is formed to allow a pillar-shaped silicon layer 202 to be buried therein.

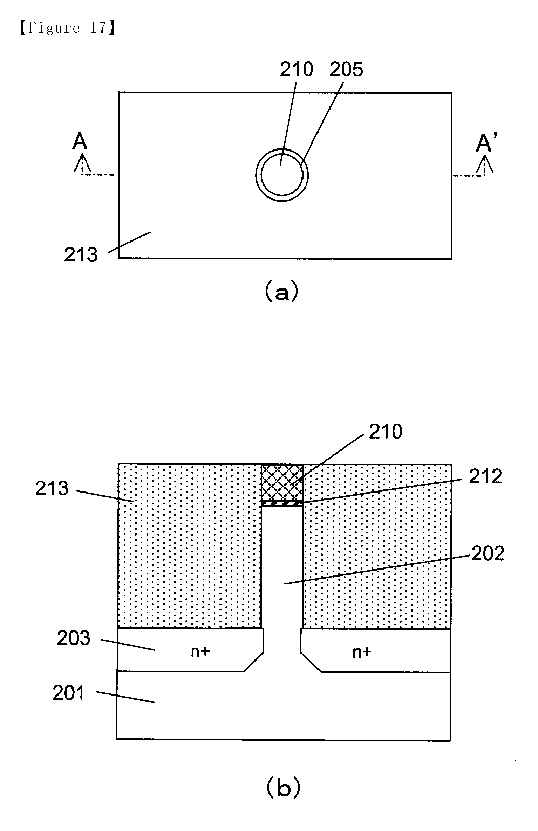

As shown in FIGS. 17(a) and 17(b), a portion of the silicon oxide film 213 above the pillar-shaped silicon layer are polished by CMP, to flatten a top surface of the silicon oxide film. During the CMP, a hard mask 210 on top of the pillar-shaped silicon layer is used as a CMP stopper. A silicon nitride film may be used as the hard mask. In this case, a selectivity ratio between the hard mask and the silicon oxide film can be set to a large value to control a CMP amount with high repeatability.

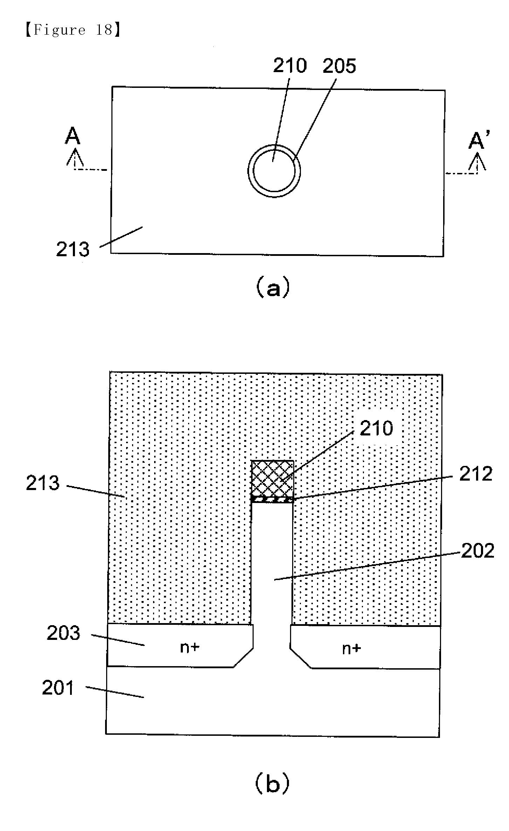

As shown in FIGS. 18(a) and 18(b), a silicon oxide film 213 is formed to allow the pillar-shaped silicon layer 202 to be buried therein.

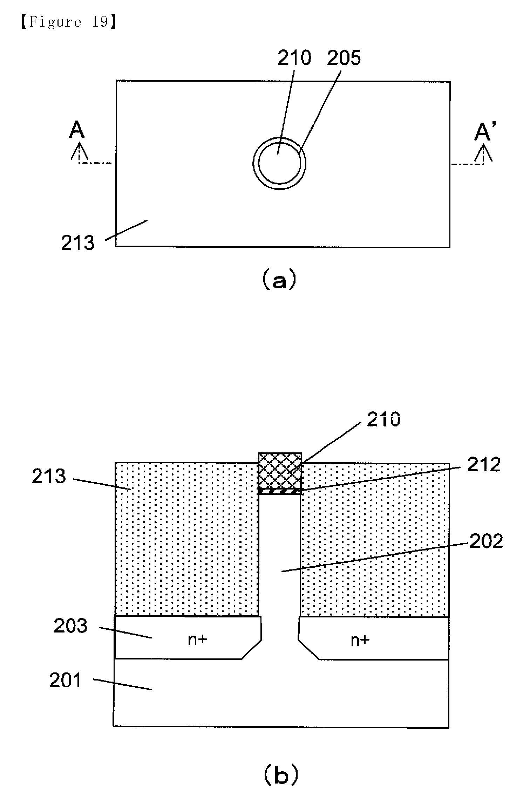

As shown in FIGS. 19(a) and 19(b), the silicon oxide film is etched back. FIG. 19(b) shows a structure at a timing when an etching end-point is detected after the silicon nitride film serving as the hard mask is exposed. An algorism for use in the end-point detection is the same as that (see FIG. 10(a)) in the first embodiment.

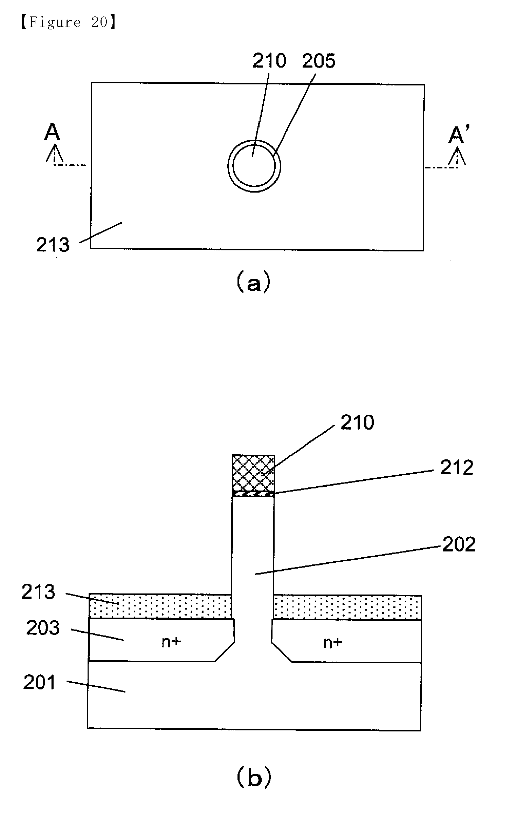

In the operation of etching back the silicon oxide film, an etching rate of the silicon oxide film 213 is calculated, and an etching time required for allowing the silicon oxide film to have a desired film thickness is determined based on the calculated etching rate, in the same manner as that in the first embodiment. Thus, after completion of dry etching, the silicon oxide film 213 is formed on the N+ drain diffusion layer 203 to have a desired film thickness for reducing a gate capacitance, as shown in FIGS. 20(a) and 20(b).

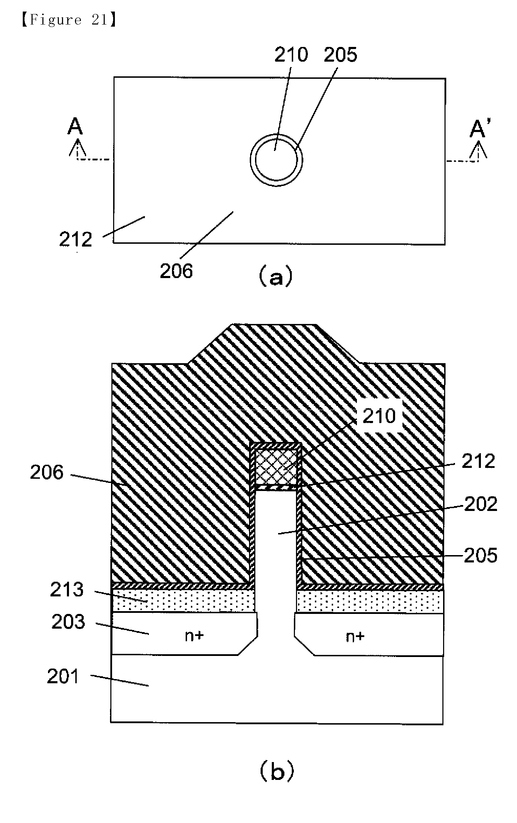

As shown in FIGS. 21 (a) and 21(b), a gate dielectric film 205 and a gate conductive film 206 are formed. Subsequent steps are the same as those in the first embodiment, and their description will be omitted here.

As described above, the SGT production method of the present invention is capable of, during dry etching for forming a gate electrode, controlling an etching amount using an end-point detection process, to stably set a gate length and a substantial height dimension of a pillar-shaped silicon layer. This makes it possible to produce an SGT with stable characteristics.

### EXPLANATION OF REFERENCE SIGNS

101, 201: silicon substrate
102, 202: pillar-shaped silicon layer
103, 203: diffusion layer beneath pillar-shaped silicon layer
104, 204: diffusion layer on top of pillar-shaped silicon layer
105, 205: gate dielectric film
106: first gate conductive film
106a: gate electrode
106b: gate line
107, 108, 108: contact
110,210: hard mask
111: second gate conductive film
112, 212: pad oxide film
213: silicon oxide film
301: silicon substrate
302: N-well
303: P-well
305: PMOS pillar-shaped silicon layer
306: NMOS pillar-shaped silicon layer
308: gate
309: P⁺ source diffusion layer
310: P⁺ drain diffusion layer
311: N⁺ source diffusion layer
312: N⁺ drain diffusion layer
402: silicon substrate
403: pillar-shaped silicon layer
404: gate dielectric film
405: gate conductive film
406: resist

## Claims

1. A method of producing a semiconductor device in which a source diffusion layer, a drain diffusion layer and a pillar-shaped semiconductor layer (102, 202) are vertically arranged on an upper side of a semiconductor substrate (101; 201) in a layered manner, and a gate is arranged around a sidewall of the pillar-shaped semiconductor layer, the method comprising the steps of:
forming a first film (106; 213) to cover respective surfaces of the pillar-shaped semiconductor layer (102; 202) and a hard mask (110, 210) formed on top of the pillar-shaped semiconductor layer;
flattening an upper portion of the first film (106; 213) using the hard mask (110; 210) as a stopper;
**characterized by** the steps:
forming a second film (111) on a surface of the flattened first film (106; 213), wherein the first and second films are made of the same material;
anisotropically etching the second film (111);
monitoring an intensity of plasma emission from the second film (111) during the etching, to detect an end-point of the etching of the second film, based on a change in the plasma emission intensity; and
anisotropically etching the flattened first film (106; 213), wherein the etching rate of the first and second films is calculated from a film thickness of the second film and a time taken from initiation to completion of the etching of the second film to detect an end-point of the etching of the flattened first film (106; 213).

2. The method according to claim 1, **characterized in that** a dielectric film (105; 205) is provided on respective surfaces of the semiconductor substrate (101; 201) and the pillar-shaped semiconductor layer (102; 202), wherein the first film is a first gate conductive film (106) and the second film is a second gate conductive film (111).

3. The method according to claim 2, **characterized in that** the first and second gate conductive films are made of polysilicon or metal material.

4. The method according to claim 1, wherein the first film is a first dielectric film (213) and the second film is a second dielectric film.

## Patentansprüche

1. Verfahren zur Herstellung einer Halbleitervorrichtung, in der eine Source-Diffusionsschicht, eine Drain-Diffusionsschicht und eine säulenförmige Halbleiterschicht (102; 202) vertikal auf einer Oberseite eines Halbleitersubstrats (101; 201) in einer geschichteten Weise angeordnet sind, und ein Gate um eine Seitenwand der säulenförmigen Halbleiterschicht angeordnet ist, wobei das Verfahren die folgenden Schritte umfasst:
Ausbilden einer ersten Schicht (106; 213) zum Bedecken der jeweiligen Flächen der säulenförmigen Halbleiterschicht (102; 210) und einer Hartmaske (110; 210), die auf der Oberseite der säulenförmigen Halbleiterschicht ausgebildet ist; Abflachen eines oberen Abschnitts der ersten Schicht (106; 213) unter Verwendung der Hartmaske (110; 210) als Stopper, **gekennzeichnet durch** die Schritte:
Ausilden einer zweiten Schicht (111) auf einer Oberfläche der abgeflachten ersten Schicht (106; 213), wobei die erste und zweite Schicht aus dem gleichen Material ausgebildet sind;
anisotropes Ätzen der zweiten Schicht (111);
Überwachen einer Intensität der Plasmaemission aus der zweiten Schicht (111) während des Ätzens, um basierend auf einer Änderung in der Plasmaemissionsintensität einen Endpunkt des Ätzens für die zweite Schicht zu erfassen; und
anisotropes Ätzen der abgeflachten ersten Schicht (106; 213), wobei die Ätzrate der ersten und zweiten Schicht aus einer Schichtdicke der zweiten Schicht und einer Zeitdauer vom Anfang bis zum Ende des Ätzens der zweiten Schicht zum Erfassen eines Endpunkts des Ätzens der abgeflachten ersten Schicht (106; 213) berechnet wird.

2. Verfahren nach Anspruch 1, **dadurch gekennzeichnet, dass** eine dielektrische Schicht (105; 205) an jeweiligen Flächen des Halbleitersubstrats (101; 201) und der säulenförmigen Halbleiterschicht (102; 210) vorgesehen ist, wobei die erste Schicht eine erste leitende Gateschicht (106) und die zweite Schicht eine zweite leitende Gateschicht (111) ist.

3. Verfahren nach Anspruch 2, **dadurch gekennzeichnet, dass** die erste leitende Gateschicht und die zweite leitende Gateschicht aus Polysilizium oder einem Metallmaterial ausgebildet sind.

4. Verfahren nach Anspruch 1, wobei die erste Schicht eine erste dielektrische Schicht (213) und die zweite Schicht eine zweite dielektrische Schicht ist.

## Revendications

1. Procédé de production d'un dispositif semi-conducteur dans lequel une couche de diffusion de source, une couche de diffusion de drain et une couche semi-conductrice en forme de colonne (102 ; 202) sont disposées verticalement sur une face supérieure d'un substrat semi-conducteur (101 ; 201), en couches successives, et une grille est disposée autour d'une paroi latérale de la couche semi-conductrice en forme de colonne, le procédé comprenant les étapes suivantes :
former un premier film (106 ; 213) pour recouvrir les surfaces respectives de la couche semi-conductrice en forme de colonne (102 ; 202) et un masque dur (110 ; 210) formé sur le dessus de la couche semi-conductrice en forme de colonne ;
aplanir une partie supérieure du premier film (106 ; 213) en utilisant le masque dur (110 ; 210) comme un tampon ;
**caractérisé par** les étapes suivantes :
former un second film (111) sur une surface du premier film aplani (106 ; 213), où les premier et second films sont constitués du même matériau ;
graver de façon anisotrope le second film (111) ;
surveiller une intensité d'émission du plasma à partir du second film (111) lors de la gravure, pour détecter un point limite de la gravure du second film, sur la base d'un changement dans l'intensité d'émission du plasma ; et
graver de façon anisotrope le premier film aplani (106 ; 213), où le taux de gravure des premier et second films est calculé à partir d'une épaisseur de film du second film et du temps pris du début à la fin de la gravure du second film pour détecter un point limite de la gravure du premier film aplani (106 ; 213).

2. Procédé selon la revendication 1, **caractérisé en ce qu'**un film diélectrique (105 ; 205) est pourvu sur les surfaces respectives du substrat semi-conducteur (101 ; 201) et de la couche semi-conductrice en forme de colonne (102 ; 202), où le premier film est un premier film conducteur de grille (106) et le second film est un second film conducteur de grille (111).

3. Procédé selon la revendication 2, **caractérisé en ce que** les premier et second films conducteurs de grille sont constitués de silicium polycristallin ou d'un matériau métallique.

4. Procédé selon la revendication 1, dans lequel le premier film est un premier film diélectrique (213) et le second film est un second film diélectrique.
